# EUROPÄISCHE PATENTSCHRIFT

(11) **EP 2 978 290 B1**
(45) Veröffentlichungstag und Bekanntmachung des Hinweises auf die Patenterteilung: **19.09.2018**
(21) Anmeldenummer: 15001998.2
(22) Anmeldetag: 04.07.2015
(51) Int. Cl.: H05K 7/14, H05K 7/20, F41G 7/22

(54) **SENSORKOPF FÜR EINEN FLUGKÖRPER**
SENSOR HEAD FOR A MISSILE
TÊTE DE CAPTEUR POUR MISSILE

(30) Priorität: 23.07.2014 DE 102014011036
(43) Veröffentlichungstag der Anmeldung: 27.01.2016
(73) Patentinhaber: Diehl Defence GmbH & Co. KG, 88662 ÜBERLINGEN (DE)
(72) Erfinder: BÄR, Klaus, DE - 91207 Lauf (DE)
(74) Vertreter: Diehl Patentabteilung

(56) Entgegenhaltungen:
- EP-A1- 0 509 394
- WO-A1-2011/031359
- WO-A2-03/048674
- US-A- 5 228 703
- US-A- 5 391 875
- US-A1- 2005 052 844
- US-A1- 2010 046 177
- US-B1- 6 404 636

## Beschreibung

Die Erfindung betrifft einen Sensorkopf für einen Flugkörper, mit einem Sensorkopfgehäuse, einer Elektronikeinheit und einem Elektronikgehäuse um die Elektronikeinheit.

Flugkörper weisen im Bugbereich ihres Rumpfes häufig einen Sensorkopf zur Messgrößenerfassung auf. Diese Messgrößenerfassung erfolgt üblicherweise durch eine im Sensorkopf angeordnete Elektronikeinheit und dient der Zielführung des Flugkörpers. Eine solche Elektronikeinheit umfasst üblicherweise eine Anzahl von Platinen, die jeweils mit einer Anzahl von elektronischen Komponenten bestückt sind.

Je nach Flugkörpertyp und Flugbedingungen kann der Sensorkopf extremen Beschleunigungen und hohen Geschwindigkeiten ausgesetzt sein. Dies ist insbesondere bei Präzisionsmunition, wie beispielsweise einem zielgeführten Artilleriegeschoss, der Fall. Die dort auftretenden Beschleunigungen können beim Abschuss bis zu 26.000 g betragen. Um eine stets präzise Zielführung des Flugkörpers zu gewährleisten, ist eine verlässliche Funktion der Elektronikeinheit auch unter solch extremen Bedingungen notwendig.

Aus der WO 2011/014287 A2 ist eine Elektronikeinheit für einen Flugkörper bekannt. Die Elektronikeinheit weist unter anderem ein Elektronikgehäuse mit einer Kavität und zwei übereinander angeordnete, durch sog. Stützstrukturen getragene Platinen auf. Das Gehäuse ist dazu vorbereitet in ein Sensorkopfgehäuse eingepasst zu werden. Zu diesem Zweck weist das Elektronikgehäuse eine der Innenkontur des Sensorkopfgehäuses entsprechende Außenkontur auf.

Die Dokumente EP 0 509 394 A1, US 2005/0052844 A1 und WO 03/048674 A2 zeigen Sensorköpfe mit in einem Elektronikgehäuse verbauten Elektronikeinheiten und einer Isolationsschicht zwischen einem Sensorkopfgehäuse und dem Elektronikgehäuse. Das Dokument US 6404636 B1 offenbart die thermische Isolierung einer Elektronikeinheit eines Flugkörpers mittels einer thermischen Diode. Es ist eine Aufgabe der vorliegenden Erfindung, einen robusten Sensorkopf anzugeben.

Diese Aufgabe wird durch einen Sensorkopf der eingangs genannten Art gelöst, bei dem erfindungsgemäß das Elektronikgehäuse die Elektronikeinheit zumindest überwiegend umhüllt und eine im Wesentlichen rotationssymmetrische Außenkontur aufweist und in einem durch das Sensorkopfgehäuse gebildeten im Wesentlichen rotationssymmetrischen Hohlraum rotationsachsenparallel angeordnet ist, wobei eine thermische Isolationsschicht zwischen dem Elektronikgehäuse und dem Sensorkopfgehäuse angeordnet ist.

Die Erfindung geht dabei von der Überlegung aus, dass Flugkörper, beispielsweise langreichweitig verschossene Rohrmunition, über große Distanzen mit hohen Geschwindigkeiten durch die Atmosphäre fliegen. Hierbei können luftreibungsbedingte Temperaturen von 250° C und darüber am Flugkörperbug auftreten. Die maximal zulässige Temperatur von Elektronikbauteilen der Elektronikeinheit liegt hingegen üblicherweise bei lediglich 100° C. Die Funktion der Elektronikeinheit - und damit beispielsweise die präzise Zielführung des Flugkörpers - kann durch die Reibungswärme während eines Fluges des Flugkörpers mit hoher Geschwindigkeit beeinträchtigt werden. Dies kann insbesondere der Fall sein, wenn der Sensorkopf zwischen dem Gehäuse der Elektronikeinheit und dem Gehäuse des Sensorkopfes eine vergleichsweise große Kontaktfläche als Wärmebrücke aufweist. Hierdurch wird die Wärmeleitung zwischen beiden Gehäusen begünstigt, sodass die Reibungswärme bis zur Elektronikeinheit vordringen, diese unzulässig stark erwärmen und folglich bis hin zum Funktionsausfall beeinträchtigen kann. Durch die Anordnung einer thermischen Isolationsschicht zwischen dem Sensorkopfgehäuse und dem Elektronikgehäuse kann diese Wärmeleitung vermindert, so die Erwärmung der Elektronikeinheit durch die Reibungswärme reduziert und folglich ein Ausfall der Elektronikeinheit durch Überhitzen vermieden werden.

Die Erfindung ist besonders vorteilhaft anwendbar bei einem Flugkörper, ausgeführt als Präzisionsmunition, insbesondere ausgeführt als gelenktes Artilleriegeschoss. Bei diesem Flugkörpertyp ist die auftretende Reibungswärme aufgrund der hohen Fluggeschwindigkeit von bis zu 1 km/s besonders hoch, sodass die thermische Isolationsschicht besonders wirksam ein Versagensrisiko der Elektronikeinheit infolge eines Überhitzens vermindern kann.

Das Sensorkopfgehäuse kann zur Montage am Rumpf eines Flugkörpers vorbereitet sein oder dazu geeignet sein, den Rumpfbug eines Flugkörpers zu bilden. Der durch das Sensorkopfgehäuse gebildete im Wesentlichen rotationssymmetrische Hohlraum kann eine Röhren-, Zylinder- und/oder Konusform aufweisen.

Die Elektronikeinheit umfasst zumindest eine Platine bzw. eine Leiterplatte mit einer Mehrzahl von Elektronikkomponenten, insbesondere optoelektronische Komponenten. Die Elektronikeinheit ist zum zumindest überwiegenden Vollbringen einer Funktion, beispielsweise einer optoelektronischen Zielerfassungsfunktion zur Zielführung des Flugkörpers, vorbereitet.

Das Elektronikgehäuse ist insbesondere koaxial im Sensorkopfgehäuse angeordnet, sodass eine drallbedingte Unwucht während eines Fluges des Flugkörpers vermindert wird. Die im Wesentlichen rotationssymmetrische Außenkontur des Elektronikgehäuses kann im Wesentlichen eine Röhren-, Zylinder- und/oder Konusform aufweisen.

Die thermische Isolationsschicht ist insbesondere radial zwischen dem Elektronikgehäuse und dem Sensorkopfgehäuse angeordnet. Die thermische Isolationsschicht kann in einem Spalt zwischen dem Elektronikgehäuse und dem Sensorkopfgehäuse angeordnet oder durch diesen gebildet sein.

In einer vorteilhaften Ausführungsform der Erfindung ist die Isolationsschicht durch einen radialen Luftspalt zwischen dem Elektronikgehäuse und dem Sensorkopfgehäuse von zumindest 1 %, vorzugsweise zumindest 2 %, des maximalen Durchmessers des Elektronikgehäuses gebildet. Das Luftspaltmaß kann durch eine entsprechende Dimensionierung des Außendurchmessers des Elektronikgehäuses und des Innendurchmessers des Sensorkopfgehäuses mit einfachen Mitteln mit einem vorgegebenen Wert realisiert werden. Der radiale Luftspalt weist ein zum Zweck der wirksamen thermischen Isolation ermitteltes Maß auf. Der Luftspalt unterscheidet sich technisch wesentlich von einem toleranzbedingten, ungewollten Spiel zwischen dem Elektronikgehäuse und dem Sensorkopfgehäuse, das bei Flugkörpern, insbesondere abschussfesten Flugkörpern, 50 µm nicht übersteigen sollte. Um eine gute thermische Isolierung zu gewährleisten, ist ein Spaltmaß von zumindest 0,2 mm, insbesondere von zumindest 0,5 mm, vorteilhaft.

Anstelle eines vollständig mit Gas gefüllten Spalts kann ein festes, plastisches oder gießbares Isolationsmaterial zumindest einen Teil der Isolationsschicht bilden. Ein die thermische Isolationsschicht bildendes Material kann zum Eingießen in den Spalt und insbesondere zum zumindest überwiegenden Ausfüllen des Spalts vorbereitet sein.

Vorteilhafterweise erstreckt sich die Isolationsschicht in tangentialer Richtung umlaufend über zumindest 270°, vorzugsweise über mehr als 330°, um das Elektronikgehäuse. Durch die derartige Ummantelung des Elektronikgehäuses mit der Isolationsschicht wird einer Bildung von Wärmebrücken zwischen dem Elektronik- und dem Sensorkopfgehäuse entgegengewirkt. Die Isolationsschicht kann sich in tangentialer Richtung abschnittsweise, also aus mehreren separaten Isolationsschichtabschnitten bestehend, um das Elektronikgehäuse erstrecken.

Zweckmäßigerweise erstreckt sich die Isolationsschicht in axialer Richtung über zumindest die Hälfte, insbesondere zumindest 80 % der axialen Länge des Elektronikgehäuses. Die Isolationsschicht kann sich in axialer Richtung abschnittsweise, also aus mehreren separaten Isolationsschichtabschnitten bestehend, über das Elektronikgehäuse erstrecken. Eine verbleibende Wärmebrücke zwischen Sensorkopf- und Elektronikgehäuse ist zweckmäßigerweise in einem Bereich angeordnet, innerhalb dessen keine oder nur einzelne, temperaturbeständige Elektronikbauelemente angeordnet sind.

Eine besonders wirksame thermische Isolation der Elektronikeinheit kann erreicht werden, wenn die Isolationsschicht einen zumindest überwiegenden Anteil, insbesondere mehr als 80 %, der Außenfläche des Elektronikgehäuses ummantelt. Dies kann besonders einfach erreicht werden, wenn das Elektronikgehäuse zumindest überwiegend an einer seiner Stirnseiten in dem Sensorkopfgehäuse befestigt wird, sodass die verbleibende Außenfläche des Elektronikgehäuses zumindest überwiegend kontaktfrei zur Innenfläche des Sensorkopfgehäuses angeordnet ist. Beispielsweise ist das Elektronikgehäuse an seiner bugseitigen Stirnseite in eine Fassung im Sensorkopfgehäuse eingesteckt, wobei die Außenfläche des Elektronikgehäuses in einem vorgegebenen Abstand zur Innenfläche des Sensorkopfgehäuses radial fixiert ist.

Weiterhin weist das Elektronikgehäuse eine über zumindest einen überwiegenden Anteil der axialen Länge des Elektronikgehäuses verlaufende Öffnung auf. Diese Öffnung kann als ein Schlitz, eine Aussparung, eine Auslassung oder ein Spalt ausgeführt sein. Die Öffnung bewirkt, dass die Elektronikeinheit teilweise nicht von dem Elektronikgehäuse umschlossen ist, sodass die Elektronikeinheit zumindest teilweise an die Isolationsschicht angrenzen kann. Die Öffnung kann so ausgeführt sein, dass sich die Isolationsschicht in das Innere des Elektronikgehäuses erstreckt. Insbesondere, wenn die Isolationsschicht als Luftspalt ausgeführt ist, entsteht durch die Öffnung im Bereich der Öffnung ein radial vertiefter Luftspalt, sodass Konvektion und/oder eine verbesserte Isolationswirkung erzielt werden kann. Vorteilhafterweise kann das Elektronikgehäuse mehrere, insbesondere zwei, solcher Öffnungen aufweisen.

Die Öffnung ist eine Lücke zwischen zwei separaten Gehäusesegmentschalen, die zumindest teilweise das Elektronikgehäuse bilden. Die Öffnung kann auf diese Weise aufwandsgünstig hergestellt werden, da auf zusätzliche Fertigungsschritte zum Einbringen der Öffnung, beispielsweise durch eine spanende Bearbeitung des Elektronikgehäuses, verzichtet werden kann. Vorteilhafterweise sind mehrere Lücken in regelmäßigen Abständen über den Umfang des Elektronikgehäuses vorgesehen. So kann eine Umwucht des Flugkörpers bei einem Rollen vermieden werden, insbesondere bei drallbehafteten Geschossen, die mit bis zu 150 U/s um ihre Längsachse rotieren.

Vorteilhafterweise weist die Lücke einen tangentialen Öffnungswinkel von zumindest 30°, vorzugsweise 60°, auf. Auf diese Weise wird eine vergleichsweise große Öffnung erreicht, sodass die Isolationsschicht, also insbesondere der Luftspalt, die Komponenten der Elektronikeinheit besser erreichen kann. Insbesondere, wenn die Elektronikeinheit mehrere in axialer Richtung übereinander beabstandet angeordnete Platinen aufweist, kann so erreicht werden, dass die Luft des Luftspalts zwischen den Platinen zirkulieren kann. Durch dieses Zirkulieren des Luftspalts kann ein konvektionsbedingter Kühleffekt erzielt werden, wodurch einer Überhitzung der Elektronikeinheit entgegengewirkt werden kann.

In einer vorteilhaften Weiterbildung weist das Elektronikgehäuse zumindest eine Gehäusesegmentschale mit einer innenliegend ausgebildeten kreisbogenförmigen Tangentialnut und einer kreiszylindrischen Außenfläche auf. In die Tangentialnut kann eine Platine oder generell ein Elektronikträger eingeführt sein, der im Folgenden der Einfachheit halber auch als Platine bezeichnet wird.

Die Außenfläche der Gehäusesegmentschale kann im Wesentlichen zylindrisch sein und sich tangential über zumindest 90°, vorzugsweise 120° erstrecken. Die Gehäusesegmentschalen können an gegenüberliegenden Seiten der Elektronikeinheit angeordnet sein und diese backenartig umfassen. Vorteilhafterweise sind mehrere Gehäusesegmentschalen in regelmäßigen Abständen über den Umfang der Elektronikeinheit angeordnet. So kann eine Umwucht des Flugkörpers bei einem Rollen während des Fluges vermieden werden.

Die Erfindung ist außerdem gerichtet auf einen Sensorkopf der eingangs genannten Art, bei dem die Elektronikeinheit erfindungsgemäß in zumindest drei parallelen Ebenen - axial übereinander angeordnet - eine erste, eine zweite und zumindest eine dritte Platine umfasst, ein erstes flexibles Flachkabel die erste mit der zweiten Platine elektrisch leitfähig verbindet, ein zweites flexibles Flachkabel die zweite mit der dritten Platine elektrisch leitfähig verbindet und die beiden flexiblen Flachkabel in axialer Richtung mäanderförmig die Platinen verbindend angeordnet sind.

Eine mäanderförmige Anordnung kann erreicht werden, wenn das erste und das zweite flexible Flachkabel an gegenüberliegenden Kanten der zweiten Platinen angeordnet sind und insbesondere bogenförmig gekrümmt in entgegengesetzte Richtungen weisen. Durch die Krümmung weisen die flexiblen Flachkabel eine größer als zur Überbrückung des Platinenabstands notwendige Länge auf. Durch diese mäanderförmige Kabelverbindung kann erreicht werden, dass die Platinen der Elektronikeinheit, sofern sie noch nicht fest in dem Elektronikgehäuse montiert sind, in hohem Maße axial zueinander beweglich sind. Insbesondere kann so eine ziehharmonikaartige Bewegung der Platinen erreicht werden, wobei einem ungewollten Lösen der elektrisch leitfähigen Verbindung durch die flexible, mäanderförmige Verbindung entgegengewirkt wird. Die Montage der Elektronikeinheit im Elektronikgehäuse kann deshalb aufwandsgünstig realisiert werden. Eine präzise und damit in der Regel aufwändige Fertigung des Elektronikgehäuses, insbesondere der zur Aufnahme der Platinen vorbereiteten Tangentialnuten, kann ebenso vermieden werden, da diese Art der Flachkabelanordnung Abstandstoleranzen ausgleichen kann.

Die Erfindung ist außerdem gerichtet auf einen Sensorkopf der eingangs genannten Art, der erfindungsgemäß eine Sensoroptik mit zumindest einem optischen Element und einen in einem axialen Abstand zum optischen Element angeordneten Sensor aufweist, wobei der axiale Abstand durch ein zumindest mittelbar zwischen dem optischen Element und dem Sensor eingefügtes Axialabstandsjustageelement justiert ist.

Die Sensoroptik kann zur optischen Erfassung von Zielen des Flugkörpers vorbereitet sein. Das optische Element der Sensoroptik ist insbesondere eine optische Linse bzw. ein Objektiv. Das optische Element kann in einem Optiklager, das beispielsweise zur Aufnahme und Fassung einer Linse vorbereitet ist, gelagert sein. Das optische Element kann ein Teil der Elektronikeinheit sein.

Der Sensor kann ein optoelektronischer Detektor sein. Zweckmäßigerweise kann der Sensor ein Teil der Elektronikeinheit, insbesondere eine auf einer Platine der Elektronikeinheit montierte elektronische Komponente, sein. Der Sensor kann in einem Sensorlager gelagert sein.

Der axiale Abstand zwischen dem optischen Element und dem Sensor kann ein bestimmter Abstand sein, der erforderlich ist, um eine Funktion des Sensorkopfes, insbesondere eine optoelektronische Zielerfassung, zu erreichen.

Das Axialabstandsjustageelement kann zwischen dem optischen Element und dem Sensor in den Sensorkopf eingelegt sein, so dass der Abstand zwischen dem optischen Element und dem Sensor durch das Axialabstandsjustageelement justiert, also eingestellt, ist. Das Axialabstandsjustageelement kann ein Ring, eine gelochte Scheibe, eine Platte mit einer Öffnung oder dergleichen sein. Beispielsweise ist das Axialabstandsjustageelement zwischen dem Sensorlager und dem Optiklager in den Sensorkopf eingefügt.

Durch das Axialabstandsjustageelement kann ein von dem bestimmten Abstand abweichender Abstand zwischen dem optischen Element und dem Sensor mit einfachen Mitteln ausgeglichen werden. Eine präzise und in der Regel aufwändige Fertigung des Sensorkopfs, insbesondere hinsichtlich des Abstandsmaßes zwischen dem optischen Element und dem Sensor, kann deshalb vermieden werden.

Zweckmäßigerweise ist das optische Element im Sensorkopfgehäuse gelagert. Das Sensorkopfgehäuse kann zu diesem Zweck eine entsprechende Fassung oder Halterung für eine optische Linse aufweisen.

In einer anderen Ausführungsvariante ist das optische Element im Elektronikgehäuse gelagert. Das Elektronikgehäuse kann hierfür eine Fassung oder eine Halterung aufweisen, in der das optische Element angeordnet ist.

Des Weiteren ist die Erfindung gerichtet auf einen Sensorkopf der eingangs genannten Art. Der Sensorkopf sieht erfindungsgemäß ein in einem axialen Abstand zu einer Kante des Elektronikgehäuses angeordnetes Schnittstellenelement vor, wobei der axiale Abstand durch ein zumindest mittelbar zwischen dem Schnittstellenelement und dem Elektronikgehäuse eingefügtes Axialabstandsjustageelement justiert ist.

Die Kante des Elektronikgehäuses ist zweckmäßigerweise eine das hintere Ende des Elektronikgehäuses bildende Kante. Das Schnittstellenelement ist beispielsweise ein Stecker, der zur Herstellung einer Steckverbindung mit einer Steckerkupplung vorbereitet ist. Außerdem kann das Schnittstellenelement zur Leitung von elektrischen Signalen vorbereitet sein, die zur Zielführung des Flugkörpers dienen. Um eine zuverlässige Herstellbarkeit der Steckverbindung zu erreichen, ist es notwendig, dass das Schnittstellenelement in einem bestimmten axialen Abstand zu der Kante des Elektronikgehäuses angeordnet ist- bzw. dass das Schnittstellenelement um einen bestimmten axialen Abstand über die heckseitige Kante des Sensorkopfgehäuses herausragt.

Das Axialabstandsjustageelement kann ein Ring, eine gelochte Scheibe oder eine Platte mit einer Öffnung sein. Beispielsweise ist das Axialabstandsjustageelement zwischen einer das Schnittstellenelement tragenden Platine und einer Wand des Elektronikgehäuses eingefügt.

Auf diese Weise kann eine präzise und in der Regel aufwändige Fertigung des Sensorkopfs, insbesondere hinsichtlich des Abstandsmaßes zwischen dem Schnittstellenelement und der Kante des Elektronikgehäuses, vermieden werden.

Zudem ist die Erfindung gerichtet auf ein System aus mehreren erfindungsgemäßen Sensorköpfen, wobei die jeweils an der gleichen Stelle angeordneten Axialabstandsjustageelemente der Sensorköpfe eine Axialdickendifferenz von zumindest 0,2 mm, vorzugsweise zumindest 0,7 mm, aufweisen. Jeder der Sensorköpfe des Systems weist zumindest ein Axialabstandsjustageelement auf. Die Axialabstandsjustageelemente des Systems sind jeweils an der gleichen Stelle angeordnet, also beispielsweise zwischen dem optischen Element und dem Sensor. Die Axialdickendifferenz ergibt sich aus dem Zweck der Abstandsjustage, die in der Regel für jeden Sensorkopf des Systems eine verschiedene Axialdicke des Axialabstandsjustageelements erfordert. In der Erprobung hat sich gezeigt, dass eine Axialdickendifferenz von zumindest 0,2 mm, vorzugsweise von 0,7 mm, zur zweckmäßigen Axialabstandsjustage für eine Vielzahl von Sensorköpfen ausreichend ist. In einigen Fällen kann es vorteilhaft sein, eine Axialdickendifferenz von mehr als 1 mm, beispielsweise 2 mm, vorzusehen.

Eine weitere vorteilhafte Ausführungsform sieht ein im Elektronikgehäuse abgestütztes Stützelement vor, das einen mittleren Bereich einer Platine der Elektronikeinheit in axialer Richtung hinterstützend angeordnet ist. Das Stützelement kann eine Verstrebung, eine Platte oder ein Balken sein, die bzw. der in dem Elektronikgehäuse befestigt ist. Die Platine liegt zumindest teilweise mit ihrem mittleren Bereich auf dem Stützelement auf. Die Platine kann eine Kreisscheibe sein. Durch das so angeordnete Abstützelement wird eine übermäßige Deformation der Platine durch die Einwirkung von Trägheitskräften während des Starts des Flugkörpers vermieden. Dies ist insbesondere bei einem als gelenktes Artilleriegeschoss ausgeführten Flugkörper von Vorteil, da die dort auftretende Abschussbeschleunigung bis zu 26.000 g erreichen kann, was ohne eine entsprechende Vorkehrung zu einer starken Deformation und/oder dem Versagen der Platine der Elektronikeinheit führen kann.

Weiterhin ist es vorteilhaft, wenn das Stützelement eine Stützwand ist und in axialer Richtung zwischen zwei Platinen der Elektronikeinheit angeordnet ist und zumindest überwiegend aus Metall besteht. Durch die Anordnung zwischen den beiden Platinen und den metallischen Werkstoff kann auf einfache Weise eine elektromagnetische Abschirmung zumindest einer der Platinen von einer elektromagnetischen Einwirkung durch die andere der beiden Platinen erfolgen. Durch die Doppelfunktion der Stützwand, nämlich der Abstützung bei einem Start und der Abschirmung gegen Strahlung, können diese Funktionen besonders aufwandsgünstig mit einem Mittel - nämlich der Stützwand - erreicht werden.

Zudem wird ein Verfahren zur Montage eines Sensorkopfs gezeigt.

Das Verfahren sieht vor, dass eine Differenz zwischen einem Sollwert und einem Istwert eines axialen Abstands zwischen zwei Elementen des Sensorkopfs ermittelt wird. Der Sollwert kann ein Wert eines axialen Abstands zu einer Einstellung, insbesondere einer Scharfstellung, des Fokus der Linse auf dem Sensor sein. Hierfür können die Elemente eine Linse und ein Sensor sein. Eine Abweichung des Istwerts des Abstands vom Sollwert des Abstands kann sich aus einer zwangsläufig unvollkommenen Fertigung ergeben. Die Differenz zwischen dem Sollwert und dem Istwert kann durch eine Messung oder mit einer Maßlehre ermittelt werden.

Unter Verwendung des ermittelten Abstandswerts wird ein Axialabstandsjustageelement mit einer bestimmten Axialdicke aus einem Satz von Axialabstandsjustageelementen mit unterschiedlichen Axialdicken ausgewählt. Der Satz von Axialabstandsjustageelementen kann eine Vielzahl von Elementen umfassen, deren Axialdicken sich bis zu 0,2 mm, insbesondere um bis zu 2 mm, voneinander unterscheiden können.

Das so ausgewählte Axialabstandsjustageelement wird im Sensorkopf montiert und hiermit der axiale Abstand zwischen der Linse und dem Sensor justiert. Auf diese Weise kann der erforderliche Abstand unter Vermeidung einer aufwändigen präzisen Fertigung bzw. eines aufwändigen Nacharbeitens an dem Sensorkopf aufwandsgünstig erreicht werden.

Es ist ebenfalls möglich, dass die beiden Elemente ein Schnittstellenelement und eine Kante eines Elektronikgehäuses des Sensorkopfs sind. Der Sollwert kann ein zu einer Herstellbarkeit einer Schnittstellenverbindung, insbesondere einer Steckverbindung, erforderlicher Wert sein. Der Istwert des Abstands ergibt sich aus der zwangsläufig unvollkommenen Fertigung bzw. aus Toleranzen des Schnittstellenelements. Die Differenz zwischen dem Sollwert und dem Istwert kann durch eine Messung oder mit einer Maßlehre ermittelt werden.

Das so ausgewählte Axialabstandsjustageelement wird im Sensorkopf montiert und hiermit der axiale Abstand zwischen dem Schnittstellenelement und der Kante des Elektronikgehäuses justiert. Auf diese Weise kann dieser erforderliche Abstand unter Vermeidung einer aufwändigen präzisen Fertigung bzw. eines aufwändigen Nacharbeitens an dem Sensorkopf aufwandsgünstig erreicht werden.

Des Weiteren wird bei einem Verfahren zur Montage eines Sensorkopfs ein Anteil einer Umfangskante einer Platine einer Elektronikeinheit in eine Nut einer Gehäusesegmentschale eines Elektronikgehäuses eingesteckt wird. Die Umfangskante der Platine kann kreisbogenförmig, insbesondere kreisförmig sein. Die Nut kann kreisbogenförmig sein. Insbesondere kann die Nut in Dickenrichtung so bemessen sein, dass eine kraftschlüssige Steckverbindung zwischen der Gehäusesegmentschale und der Platine erreicht wird. Die Gehäusesegmentschale kann mehrere Nuten zur Aufnahme mehrerer Platinen aufweisen. Es kann möglich sein, mehr als eine Platine in eine Nut einzustecken.

Eine mit einer weiteren Nut versehene weitere Gehäusesegmentschale wird mit dieser weiteren Nut auf einen weiteren Anteil der Umfangskante der Platine aufgesteckt.

Zweckmäßigerweise wird die Gehäusesegmentschale auf die der ersten Gehäusesegmentschale gegenüberliegende Umfangskante bzw. bei einer umlaufenden Umfangskante auf die gegenüberliegende Seite, aufgesteckt, sodass die Platine backenartig durch die beiden Gehäusesegmentschalen umgriffen wird.

Die Platine wird von den Gehäusesegmentschalen in radialer Richtung zwischen diesen fixiert und hiermit zumindest ein Teil der Elektronikeinheit - nämlich die Platine - in dem Elektronikgehäuse montiert. Durch die beschriebene Steckverbindung zwischen mehreren, insbesondere zwei, Gehäusesegmentschalen, ist die Elektronikeinheit besonders einfach in dem Elektronikgehäuse montierbar. Ferner sind die Platine bzw. deren elektronische Komponenten durch ein bloßes Entfernen einer der Gehäusesegmentschalen gut erreichbar, was beispielsweise zum Entfernen und Ersetzen einer elektronischen Komponente vorteilhaft sein kann.

Die bisher gegebene Beschreibung vorteilhafter Ausgestaltungen der Erfindung enthält zahlreiche Merkmale, die in den einzelnen Unteransprüchen teilweise zu mehreren zusammengefasst wiedergegeben sind. Diese Merkmale können jedoch zweckmäßigerweise auch einzeln betrachtet und zu sinnvollen weiteren Kombinationen zusammenfasst werden. Insbesondere sind diese Merkmale jeweils einzeln und in beliebiger geeigneter Kombination mit der erfindungsgemäßen Vorrichtung gemäß des unabhängigen Anspruchs kombinierbar.

Die oben beschriebenen Eigenschaften, Merkmale und Vorteile dieser Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und/oder mit einem beliebigen der Ansprüche kombiniert werden.

Es zeigen:
- FIG 1: einen Flugkörper mit einem Sensorkopf mit einem Sensorkopfgehäuse und einer Bughaube,
- FIG 2: den Sensorkopf aus FIG 1 mit einer im Inneren des Sensorkopfgehäuses montierter Elektronikeinheit in einer Schnittdarstellung,
- FIG 3: den Sensorkopf aus FIG 1 in einer Schnittdarstellung mit einer relativ zu FIG 2 um 90° gedrehten Schnittebene,
- FIG 4: ein Elektronikgehäuse mit Gehäusesegmentschalen und der Elektronikeinheit aus FIG 2,
- FIG 5: das Elektronikgehäuse und die Elektronikeinheit aus FIG 4 in einer Schnittdarstellung und
- FIG 6: ein System aus mehreren Sensorköpfen.

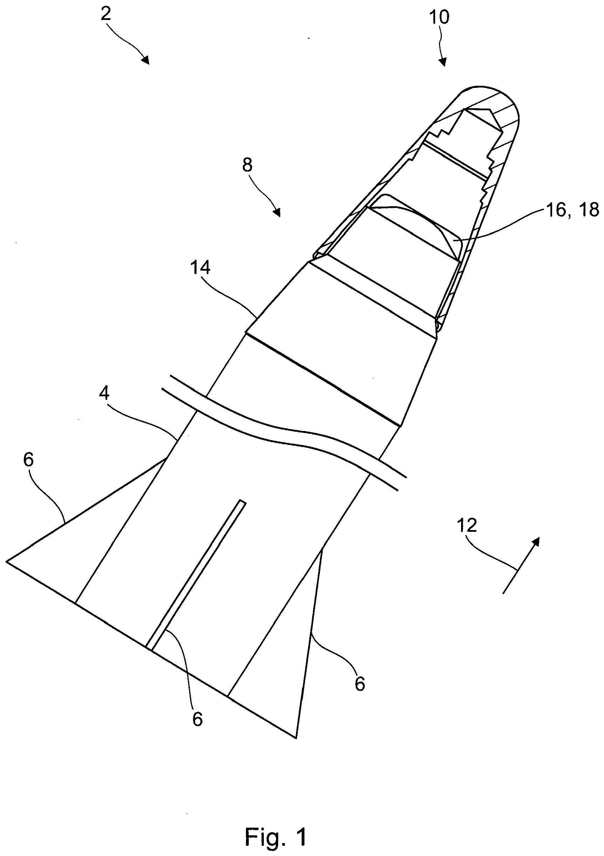

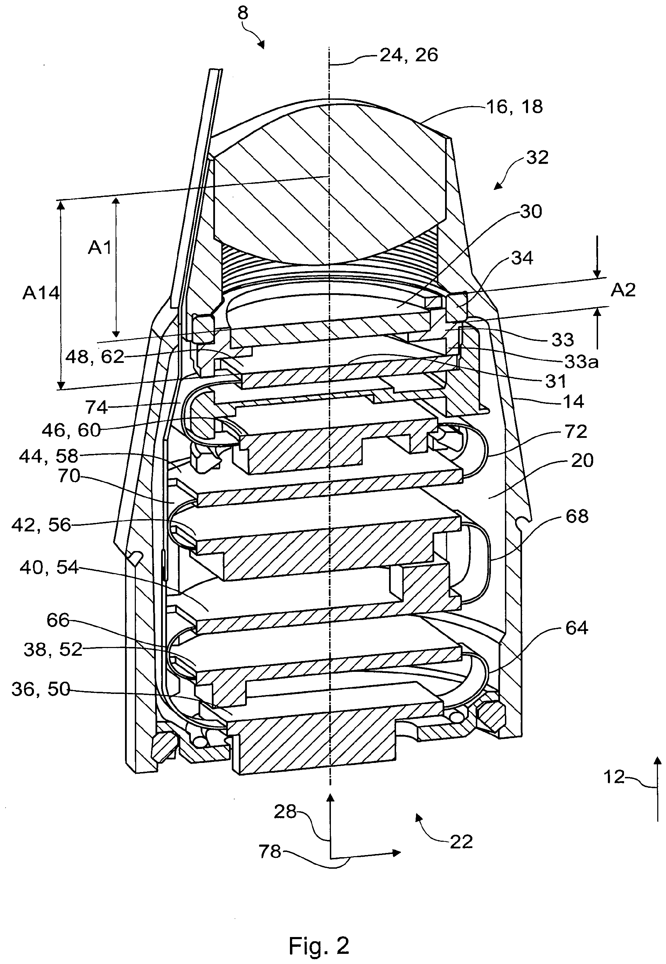

FIG 1 zeigt eine schematische Darstellung eines Flugkörpers 2 mit einem Rumpf 4 mit heckseitig ausgebildeten Tragflügeln 6, einem Sensorkopf 8 und einer Bughaube 10. Die Bughaube 10 ist in einem Längsschnitt dargestellt und bildet den in einer Flugrichtung 12 vordersten Teil des Flugkörpers 2. Der Sensorkopf 8 weist ein rotationssymmetrisches Sensorkopfgehäuse 14 und ein optisches Element 16 auf, das im vorliegenden Ausführungsbeispiel als optische Linse 18 ausgeführt ist. Der Sensorkopf 8 ist zur Erfassung von Zielen und/oder zur Zielführung des Flugkörpers 2 mittels des optischen Elements 16 und einer im Inneren des Sensorkopfgehäuses 14 montierten Elektronikeinheit 22 (siehe FIG 2) vorbereitet. Die Bughaube 10 ist auf das Sensorkopfgehäuse 14 aufgesteckt und deckt insbesondere das optische Element 16 bzw. die optische Linse 18 zum Schutz vor Beschädigungen ab.

Im vorliegenden Ausführungsbeispiel ist der Flugkörper 2 als gelenktes Artilleriegeschoss ausgeführt, sodass die Fluggeschwindigkeit des Flugkörpers 2 bis zu 1 km/s beträgt. Durch die dabei auftretende Luftreibung treten hohe Temperaturen von bis zu 300° C an der Außenfläche des Flugkörpers 2, insbesondere am vordersten Bereich des Flugkörpers 2 bzw. dessen Bug, auf.

Nach einem Start des Flugkörpers 2 und in einer frühen Flugphase ist die Bughaube 10 in der Regel das durch die Luftreibung thermisch am höchsten beanspruchte Bauteil des Flugkörpers 2.

Die Bughaube 10 ist zum Abwerfen zu einem vorgegebenen Zeitpunkt während eines Fluges des Flugkörpers 2 vorbereitet, sodass der Sensorkopf 8 nach diesem vorgegebenen Zeitpunkt bis zum Eintreffen des Flugkörpers 2 in einem Ziel den vordersten Bereich des Flugkörpers 2 bildet. Infolgedessen wird das Sensorkopfgehäuse 14 ab diesem vorgegebenen Zeitpunkt durch die einwirkende Reibungswärme thermisch hoch beansprucht. Die Reibungswärme wird durch die Wärmeleitung teilweise bis in das Innere des Sensorkopfgehäuses 14 transportiert und führt so zu einer Erwärmung der in dessen Inneren montierten Komponenten. Um eine unzulässig hohe thermische Beanspruchung der im Inneren des Sensorkopfgehäuses 14 angeordneten Elektronikeinheit 22 - und damit einen möglichen Ausfall der Zielführungsfunktion des Flugkörpers 2 - zu vermeiden, müssen entsprechende technische Vorkehrungen getroffen werden.

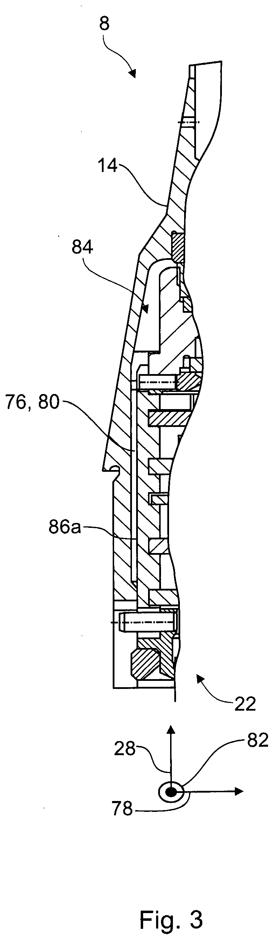

FIG 2 zeigt den Sensorkopf 8 mit dem Sensorkopfgehäuse 14 aus FIG 1 in einem Längsschnitt. Das Sensorkopfgehäuse 14 bildet einen im Wesentlichen rotationssymmetrischen Hohlraum 20 in dem die Elektronikeinheit 22 angeordnet ist. Die Elektronikeinheit 22 wird zumindest überwiegend von einem Elektronikgehäuse 84 (siehe FIG 3) umhüllt, das aufgrund der gewählten Schnittebene in FIG 2 und einer teilweisen Verdeckung durch die Elektronikeinheit 22 nicht dargestellt ist. Die Rotationsachse 24 des Sensorkopfgehäuses 14 und die Rotationsachse 26 des Elektronikgehäuses 84 sind koaxial angeordnet.

In axialer Richtung 28 oberhalb der Elektronikeinheit 22 ist eine das optische Element 16 bzw. die optische Linse 18, einen Filter 30 und einen auf einer Platine 48 angeordneten Sensor 31 umfassende Sensoroptik 32 angeordnet, wobei das optische Element 16 im Sensorkopfgehäuse 14 gelagert ist. In einem anderen vorliegend nicht näher beschriebenen Ausführungsbeispiel kann das optische Element 16 im Elektronikgehäuse 84 gelagert sein. Das optische Element 16 bzw. die optische Linse 18 ist in einem axialen Abstand A1 zum Filter 30 angeordnet, wobei der axiale Abstand A1 durch ein zumindest mittelbar zwischen der optischen Linse 18 und dem Filter 30 eingefügtes Axialabstandsjustageelement 34 justiert ist. Das Axialabstandsjustageelement 34 ist im vorliegenden Ausführungsbeispiel ein Kreisring mit einem rechteckigen Querschnitt. Der dem Sensor 31 vorgeordnete Filter 30 ist in einer kreisförmigen Halterung 33 gehaltert, auf der zum einen das Axialabstandsjustageelement 34 zumindest teilweise aufliegt und die zum anderen einen Fortsatz 33a mit rechteckförmigem Querschnitt aufweist, wobei die den Sensor 31 tragende Platine 48 und die Halterung 33 über den Fortsatz 33a zumindest bereichsweise miteinander verbunden sind. Die Halterung 33 sorgt somit für einen definierten axialen Abstand zwischen Filter 30 und Sensor 31.

Zur Montage des Sensorkopfs 8 wird eine Differenz zwischen einem Sollwert und einem Istwert des axialen Abstands A1 zwischen der optischen Linse 18 und dem Filter 30 ermittelt. Der Sollwert ist im vorliegenden Ausführungsbeispiel ein Wert zu einer Einstellung des Fokus der optischen Linse 18 auf dem Sensor 31, welcher sich über die Halterung 33 in einem definierten Abstand zum Filter 30 befindet. Die Abweichung des Istwerts des Abstands A1 vom Sollwert des Abstands A1 ergibt sich infolge von Fertigungsungenauigkeiten des Sensorkopfs 8, insbesondere des Sensorkopfgehäuses 14 und des Elektronikgehäuses 84. Die Differenz zwischen dem Sollwert und dem Istwert wird durch eine Messung ermittelt.

Unter Verwendung des so ermittelten Abstandswerts wird das Axialabstandsjustageelement 34 mit einer bestimmten Axialdicke A2 aus einem Satz von Axialabstandsjustageelementen mit unterschiedlichen Axialdicken ausgewählt. Bei einem anderen Sensorkopf würde infolge anderer Fertigungsabweichungen dementsprechend ein anderes Axialabstandsjustageelement mit einer von A2 abweichenden Axialdicke ausgewählt werden. Das so ausgewählte Axialabstandsjustageelement 34 wird im Sensorkopfgehäuse 14 montiert und hiermit der axiale Abstand A1 zwischen der Linse 18 und dem Filter 30 und damit auch der axiale Abstand A14 zwischen Linse 18 und Sensor 31 justiert bzw. der Fokus der Linse 18 auf dem Sensor 31 eingestellt.

Die Elektronikeinheit 22 weist sieben Platinen 36, 38, 40, 42, 44, 46 und 48 auf, die in sieben Ebenen 50, 52, 54, 56, 58, 60 und 62 in axialer Richtung 28 übereinander angeordnet sind. Die Platinen 36 bis 48 sind mit sechs flexiblen Flachkabeln 64, 66, 68, 70, 72 und 74 verbunden. Genauer, verbindet jeweils elektrisch leitfähig das erste Flachkabel 64 die erste Platine 36 mit der zweiten Platine 38, das zweite Flachkabel 66 die zweite Platine 38 mit der dritten Platine 40, das dritte Flachkabel 68 die dritte Platine 40 mit der vierten Platine 42, das vierte Flachkabel 70 die vierte Platine 42 mit der fünften Platine 44, das fünfte Flachkabel 72 die fünfte Platine 44 mit der sechsten Platine 46 und das sechse Flachkabel 74 die sechste Platine 46 mit der siebten Platine 48. Die flexiblen Flachkabel 64, 66, 68, 70, 72 und 74 sind dabei in axialer Richtung 28 mäanderförmig gewunden angeordnet. Durch die sich so ergebende Krümmung weisen die flexiblen Flachkabel 64, 66, 68, 70, 72 und 74 jeweils eine größere als zur Überbrückung des jeweiligen Platinenabstands notwendige Länge auf.

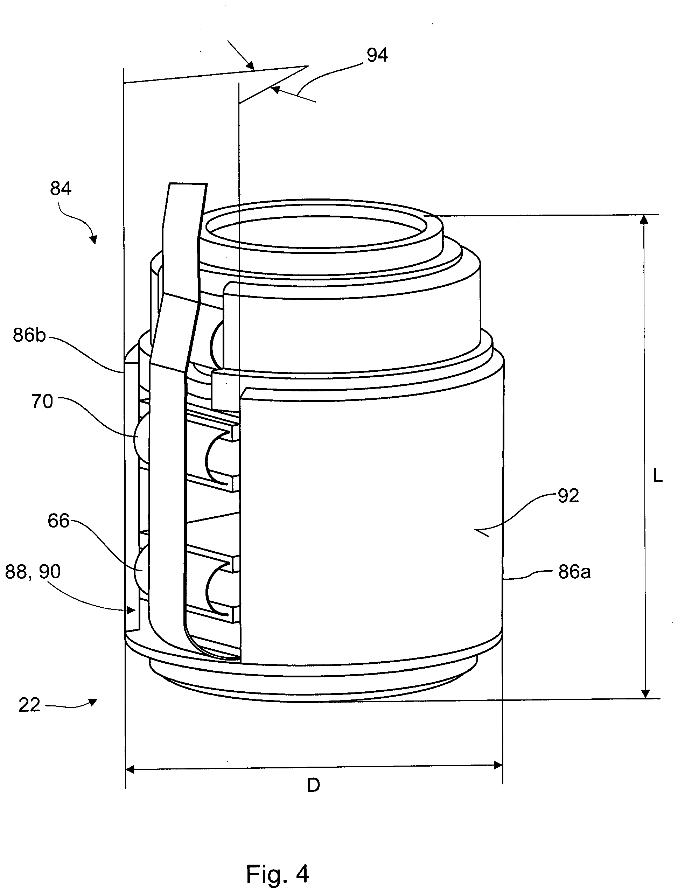

FIG 3 zeigt den Sensorkopf 8 aus FIG 1 in einer Schnittdarstellung mit einer relativ zu FIG 2 um 90° gedrehten Schnittebene, wobei die Darstellung durch eine Bruchkante auf die hier zu verdeutlichenden Merkmale beschränkt wird. Die Elektronikeinheit 22 wird zumindest überwiegend von einem Elektronikgehäuse 84. umhüllt Das Elektronikgehäuse 84 weist eine Gehäusesegmentschale 86a auf. Zwischen dem Elektronikgehäuse 84 und dem Sensorkopfgehäuse 14 ist eine thermische Isolationsschicht 76 angeordnet. Im vorliegenden Ausführungsbeispiel wird diese Isolationsschicht 76 durch einen radialen Luftspalt 80 gebildet. Im Bereich der Gehäusesegmentschale weist der Luftspalt 80 ein Spaltmaß von etwa 0,5 mm auf. In tangentialer Richtung 82 erstreckt sich die Isolationsschicht 76 bzw. der Luftspalt 80 annähernd vollständig um das Elektronikgehäuse 84 herum. In axialer Richtung 28 erstreckt sich der Luftspalt 80 annähernd über die gesamte axiale Länge L (siehe FIG 4) des Elektronikgehäuses 84.

FIG 4 zeigt das Elektronikgehäuse 84 aus FIG 3 mit zwei Gehäusesegmentschalen 86a, 86b und die im Inneren des Elektronikgehäuses 84 angeordneten Elektronikeinheit 22 in einer perspektivischen Ansicht. Die nachfolgenden Beschreibungen beschränken sich im Wesentlichen auf die Unterschiede zu den vorhergehenden Ausführungsbeispielen, auf die bezüglich gleich bleibender Merkmale und Funktionen verwiesen wird. Im Wesentlichen gleich bleibende Bauteile sind grundsätzlich mit der gleichen Bezugsziffer gekennzeichnet und nicht erwähnte Merkmale sind in den folgenden Ausführungsbeispielen übernommen, ohne dass sie erneut beschrieben sind.

Das Elektronikgehäuse 84 weist eine im Wesentlichen rotationssymmetrische Außenkontur mit einem maximalen Durchmesser D und einer axialen Länge L und eine sich über annähernd die gesamte axiale Länge L erstreckende Öffnung 88 auf. Das Elektronikgehäuse 84 umhüllt die Elektronikeinheit 22 überwiegend, wobei insbesondere die flexiblen Flachkabel 66 und 70 der Elektronikeinheit 22 in der Öffnung 88 angeordnet sind.

Im vorliegenden Ausführungsbeispiel ist die Öffnung 88 als Lücke 90 zwischen den separaten Gehäusesegmentschalen 86a und 86b, die jeweils eine kreiszylindrische Außenfläche 92 des Elektronikgehäuses 84 bilden, ausgeführt. Die Lücke weist einen tangentialen Öffnungswinkel 94 von 60° auf. Aufgrund der perspektivischen Darstellung in FIG 3 ist eine weitere identische um 180° zur Lücke 90 versetzte Lücke nicht erkennbar. Die Lücke 90 ermöglicht eine Belüftung der Elektronikeinheit 22.

In dem in FIG 2 und FIG 3 dargestellten Einbauzustand der Elektronikeinheit 22 im Sensorkopfgehäuse 14 umhüllt der Luftspalt 80 die Gehäusesegmentschalen 86a, sodass im Bereich der Gehäusesegmentschalen 86a, 86b eine Wärmebrücke zum Sensorkopfgehäuse 14 vermieden wird.

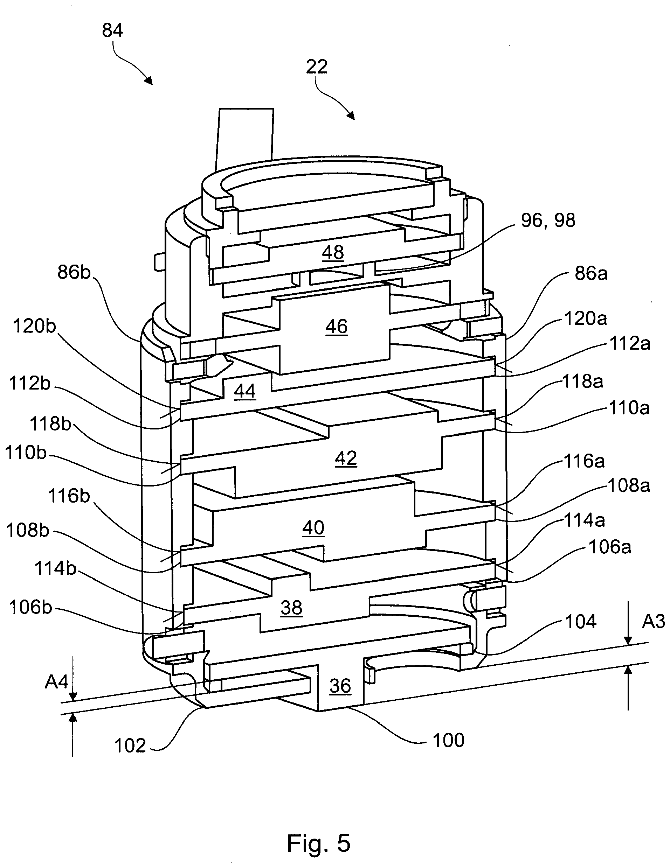

FIG 5 zeigt das Elektronikgehäuse 84 mit den beiden Gehäusesegmentschalen 86a und 86b und die Elektronikeinheit 22 aus FIG 4 in einer weiteren Schnittdarstellung. Wie in dieser Darstellung ersichtlich weist das Elektronikgehäuse 84 ein Stützelement 96 auf, das einen mittleren Bereich der Platine 48 in axialer Richtung 28 hinterstützt. Das Stützelement 96 ist als Stützwand 98 ausgeführt und in axialer Richtung 28 zwischen den beiden Platinen 46 und 48 angeordnet. Die Stützwand besteht überwiegend aus einem Metall, sodass die Platine 46 von eineretwaigen von der Platine 48 ausgehenden elektromagnetischen Abstrahlung abgeschirmt wird.

Zudem weist die Elektronikeinheit 22 ein Schnittstellenelement 100 auf. Das Schnittstellenelement 100 ist auf der Platine 36 angeordnet und überragt eine Kante 102 des Elektronikgehäuses 84 um einen Abstand A3. Zwischen der Platine 36 - und so zumindest mittelbar zwischen dem Schnittstellenelement 100 und dem Elektronikgehäuse 22 - ist ein weiteres Axialabstandsjustageelement 104 eingefügt. Das Axialabstandsjustageelement 104 ist im vorliegenden Ausführungsbeispiel als ein Kreisring mit einem rechteckigen Querschnitt ausgeführt.

Zur Montage des Sensorkopfs 8 wird eine Differenz zwischen einem Sollwert und einem Istwert des axialen Abstands A3 zwischen dem Schnittstellenelement 100 und der Kante 102 des Elektronikgehäuses 84 ermittelt. Der Sollwert ist im vorliegenden Ausführungsbeispiel ein Wert zur anforderungsgerechten Herstellung einer Steckverbindung zwischen dem Schnittstellenelement 100 und einem nicht näher bezeichneten Schnittstellengehäuse. Die Abweichung des Istwerts des Abstands A3 vom Sollwert des Abstands A3 ergibt sich infolge von Fertigungsungenauigkeiten des Sensorkopfs 8, insbesondere des Elektronikgehäuses 84. Die Differenz zwischen dem Sollwert und dem Istwert wird durch eine Maßlehre ermittelt.

Unter Verwendung des so ermittelten Abstandswerts wird das Axialabstandsjustageelement 104 mit einer bestimmten Axialdicke A4 aus einem Satz von Axialabstandsjustageelementen mit unterschiedlichen Axialdicken ausgewählt. Bei einem anderen Sensorkopf würde infolge anderer Fertigungsabweichungen dementsprechend ein anderes Axialabstandsjustageelement mit einer von A4 abweichenden Axialdicke ausgewählt werden. Das so ausgewählte Axialabstandsjustageelement 104 wird im Elektronikgehäuse 84 montiert und hiermit der axiale Abstand A3 zwischen dem Schnittstellenelement 100 und der Kante 102 justiert.

Die Gehäusesegmentschalen 86 weisen eine Mehrzahl von kreisbogenförmigen Tangentialnuten 106, 108, 110 und 112 auf. Die Kantenflächen der Platinen 38, 40, 42 und 44 sind in die Tangentialnuten 106, 108, 110 und 112 eingefügt.

Zur Montage der Elektronikeinheit 22 in dem Elektronikgehäuse 84 werden die Platinen 38, 40, 42 und 44 in die Tagentialnuten 106, 108, 110 und 112 eingesteckt und so zwischen den Gehäusesegmentschalen 86 fixiert. Genauer, werden die Umfangskante 114a der Platine 38 in die Tangentialnut 106a, die Umfangskante 116a der Platine 40 in die Tangentialnut 108a, die Umfangskante 118a der Platine 42 in die Tangentialnut 110a und die Umfangskante 120a der Platine 44 in die Tangentialnut 112a der Gehäusesegmentschale 86a eingesteckt. Hiernach wird die Gehäusesegmentschale 86b mit den Tagentialnuten 106b, 108b, 110b und 112b auf die so teilweise fixierten Platinen 38, 40, 42 und 44 aufgesteckt. Genauer, wird die Gehäusesegmentschale 86b mit der Tangentialnut 106b auf die Umfangskante 114b der Platine 38, der Tangentialnut 108b auf die Umfangskante 116b der Platine 40, der Tangentialnut 110b auf die Umfangskante 118b der Platine 42 und der Tangentialnut 112b auf die Umfangskante 120b der Platine 44 aufgesteckt. In der Weise werden die Platinen 38 bis 44 zwischen den Gehäusesegmentschalen 86 in radialer Richtung 78 und axialer Richtung 28 fixiert.

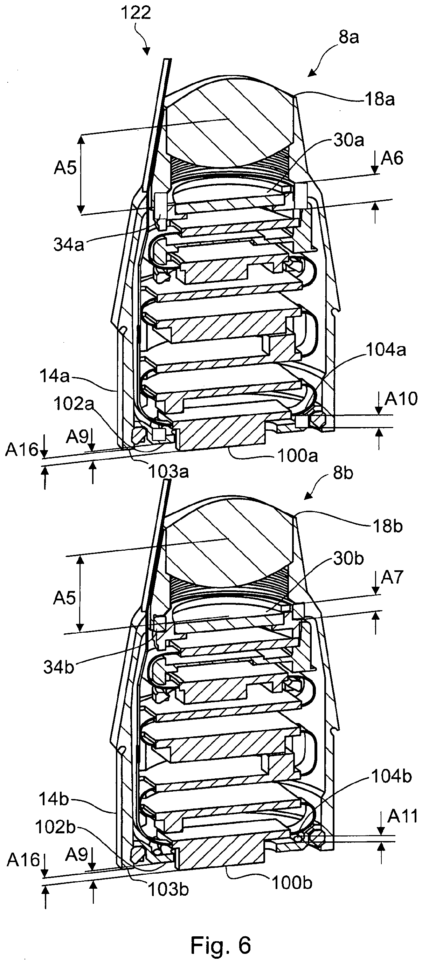

FIG 6 zeigt eine schematische Darstellung eines Systems 122 aus mehreren Sensorköpfen 8, wobei sich Darstellung aus Gründen der Übersichtlichkeit auf lediglich zwei Sensorköpfe 8a und 8b beschränkt.

Bei dem Sensorkopf 8a ist die optische Linse 18a in einem axialen Abstand A5 zum Filter 30a angeordnet, wobei der axiale Abstand A5 durch das Axialabstandsjustageelement 34a justiert ist. Bei dem Sensorkopf 8b ist dessen optische Linse 18b zum Filter 30b ebenfalls in dem axialen Abstand A5 angeordnet. Der axiale Abstand A5 ist bei dem Sensorkopf 8b durch das Axialabstandsjustageelement 34b justiert. Die Axialabstandsjustageelemente 34a und 34b weisen unterschiedliche Axialdicken A6 bzw. A7 auf. Im vorliegenden Ausführungsbeispiel beträgt die Axialdickendifferenz A8=|A6-A7| etwa 0,5 mm.

Zudem ist bei dem Sensorkopf 8a ist das Schnittstellenelement 100a in einem axialen Abstand A9 zur Kante 102a angeordnet, wobei der axiale Abstand A9 durch das Axialabstandsjustageelement 104a justiert ist. Bei dem Sensorkopf 8b ist dessen Schnittstellenelement 100b zur Kante 102b ebenfalls in dem axialen Abstand A9 angeordnet. Der axiale Abstand A9 ist bei dem Sensorkopf 8b durch das Axialabstandsjustageelement 104b justiert. Die Axialabstandsjustageelemente 104a und 104b weisen unterschiedliche Axialdicken A10 bzw. A11 auf. Im vorliegenden Ausführungsbeispiel beträgt die Axialdickendifferenz A12=|A10-A11| etwa 0,1 mm.

Durch die Justage des axialen Abstands A9 wird gleichzeitig der Abstand A16, der Abstand von heckseitiger Kante 103 des Sensorkopfgehäuses 14 zum Schnittstellenelement 100 justiert, um eine Realisierung einer Steckverbindung zwischen dem Schnittstellenelement 100 und einem nicht näher dargestellten Schnittstellengehäuse zu ermöglichen. Hierzu ist es erforderlich, dass das Schnittstellenelement 100 um den Abstand A16 über die heckseitige Kante 103 des Sensorkopfgehäuses 14 herausragt.

### Bezugszeichenliste

- 2: Flugkörper
- 4: Rumpf
- 6: Tragflügel
- 8, 8a, 8b: Sensorkopf
- 10: Bughaube
- 12: Flugrichtung
- 14: Sensorkopfgehäuse
- 16: optisches Element
- 18, 18a, 18b: optische Linse
- 20: Hohlraum
- 22: Elektronikeinheit
- 24, 26: Rotationsachse
- 28: Axialrichtung
- 30, 30a, 30b: Filter
- 31: Sensor
- 32: Sensoroptik
- 33: Halterung
- 33a: Fortsatz
- 34, 34a, 34b: Axialabstandsjustageelement
- 36, 38, 40, 42, 44, 46, 48: Platine
- 50, 52, 54, 56, 58, 60, 62: Ebenen
- 64, 66, 68, 70, 72, 74: flexibles Flachkabel
- 76: thermische Isolationsschicht
- 78: Radialrichtung
- 80: Luftspalt
- 82: Tangentialrichtung
- 84: Elektronikgehäuse
- 86a, 86b: Gehäusesegmentschale
- 88: Öffnung
- 90: Lücke
- 92: Außenfläche
- 94: Öffnungswinkel
- 96: Stützelement
- 98: Stützwand
- 100, 100a, 100b: Schnittstellenelement
- 102, 102a, 102b: Kante
- 103: Kante
- 104, 104a, 104b: Axialabstandsjustageelement
- 106a, 106b: Tangentialnut
- 108a, 108b: Tangentialnut
- 110a, 110b: Tangentialnut
- 112a, 112b: Tangentialnut
- 114a, 114b: Umfangskante
- 116a, 116b: Umfangskante
- 118a, 118b: Umfangskante
- 120a, 120b: Umfangskante
- 122: System mehrerer Sensorköpfe
- A1, A3, A5, A9, A14, A16: Axialabstand
- A2, A4, A6, A7, A10, A11: Axialdicke
- A8, A12: Axialdickendifferenz
- D: maximaler Durchmesser
- L: axiale Länge

## Patentansprüche

1. Sensorkopf (8) für einen Flugkörper (2), mit einem Sensorkopfgehäuse (14), einer Elektronikeinheit (22) und einem Elektronikgehäuse (84) um die Elektronikeinheit (22), wobei
a) das Elektronikgehäuse (84) die Elektronikeinheit (22) zumindest überwiegend umhüllt und eine im Wesentlichen rotationssymmetrische Außenkontur (92) aufweist und in einem durch das Sensorkopfgehäuse (14) gebildeten rotationssymmetrischen Hohlraum (20) rotationsachsenparallel (24, 26) angeordnet ist
b) eine thermische Isolationsschicht (76) zwischen dem Elektronikgehäuse (84) und dem Sensorkopfgehäuse (14) angeordnet ist,
c) das Elektronikgehäuse (84) eine über zumindest einen überwiegenden Anteil der axialen Länge (L) des Elektronikgehäuses (84) verlaufende Öffnung (88) aufweist, wobei die Öffnung eine Lücke zwischen zwei separaten Gehäuseschalen (86a, 86b) ist, und
d) das Elektronikgehäuse (84) zumindest teilweise durch die zwei separaten Gehäuseschalen (86a, 86b) gebildet ist.

2. Sensorkopf (8) nach Anspruch 1,
wobei die Isolationsschicht (76) durch einen radialen (78) Luftspalt (80) zwischen dem Elektronikgehäuse (84) und dem Sensorkopfgehäuse (14) von zumindest 1 %, vorzugsweise 2 %, des maximalen Durchmessers (D) des Elektronikgehäuses (84) gebildet ist.

3. Sensorkopf (8) nach Anspruch 1 oder 2,
wobei sich die Isolationsschicht (76) in tangentialer Richtung (82) umlaufend über zumindest 270°, vorzugsweise über mehr als 330°, um das Elektronikgehäuse (84) erstreckt.

4. Sensorkopf (8) nach einem der vorhergehenden Ansprüche,
wobei sich die Isolationsschicht (76) in axialer Richtung (28) über zumindest die Hälfte der axialen Länge (L) des Elektronikgehäuses (84) erstreckt.

5. Sensorkopf (8) nach einem der vorhergehenden Ansprüche,
wobei die Lücke (90) einen tangentialen Öffnungswinkel (94) von zumindest 30°, vorzugsweise 60°, aufweist.

6. Sensorkopf (8) nach einem der vorhergehenden Ansprüche,
wobei die zumindest zwei separaten Gehäusesegmentschalen (86a, 86b) eine innenliegend ausgebildete kreisbogenförmige Tangentialnut (106a-112a, 106b-112b) und eine kreiszylindrische Außenfläche (92) aufweisen.

7. Sensorkopf (8) nach einem der vorhergehenden Ansprüche,
wobei die Elektronikeinheit (22) in zumindest drei parallelen Ebenen (50, 52, 54) - axial übereinander angeordnet - eine erste (36), eine zweite (38) und zumindest eine dritte Platine (40) umfasst, ein erstes flexibles Flachkabel (64) die erste (36) mit der zweiten Platine (38) elektrisch leitfähig verbindet, ein zweites flexibles Flachkabel (66) die zweite (40) mit der dritten Platine (42) elektrisch leitfähig verbindet und die beiden flexiblen Flachkabel (64, 66) in axialer Richtung (28) mäanderförmig die Platinen (36, 38, 40) verbindend angeordnet sind.

8. Sensorkopf (8) nach einem der vorhergehenden Ansprüche,
mit einer Sensoroptik (32) mit zumindest einem optischen Element (16) und einem in einem axialen Abstand (A14) zum optischen Element (16) angeordneten Sensor (31), wobei der axiale Abstand (A14) durch ein zumindest mittelbar zwischen dem optischen Element (16) und dem Sensor (31) eingefügtes Axialabstandsjustageelement (34) justiert ist.

9. Sensorkopf (8) nach Anspruch 8,
wobei das optische Element (16) im Sensorkopfgehäuse (14) oder im Elektronikgehäuse (84) gelagert ist.

10. Sensorkopf (8) nach einem der vorhergehenden Ansprüche,
mit einem in einem axialen Abstand (A3) zu einer Kante (102) des Elektronikgehäuses (84) angeordnetem Schnittstellenelement (100) zur Leitung von elektrischen Signalen, wobei der axiale Abstand (A3) durch ein zumindest mittelbar zwischen dem Schnittstellenelement (100) und dem Elektronikgehäuse (84) eingefügtes Axialabstandsjustageelement (104) justiert ist.

11. System (122) aus mehreren Sensorköpfen (8a, 8b) nach einem der Ansprüche 8 bis 10,
wobei die jeweils an der gleichen Stelle angeordneten Axialabstandsjustageelemente (34a, 34b) (104a, 104b) der Sensorköpfe (8a, 8b) eine Axialdickendifferenz (A8, A12) von zumindest 0,2 mm, vorzugsweise zumindest 0,7 mm, aufweisen.

## Claims

1. Sensor head (8) for a missile (2), comprising a sensor head housing (14), an electronics unit (22) and an electronics housing (84) around the electronics unit (22), wherein
a) the electronics housing (84) at least predominantly encloses the electronics unit (22) and has a substantially rotationally symmetrical outer contour (92) and is arranged with parallel rotation axes (24, 26) in a rotationally symmetrical cavity (20) which is formed by the sensor head housing (14),
b) a thermal insulation layer (76) is arranged between the electronics housing (84) and the sensor head housing (14),
c) the electronics housing (84) has an opening (88) which runs over at least a major portion of the axial length (L) of the electronics housing (84), wherein the opening is a gap between two separate housing channels (86a, 86b), and
d) the electronics housing (84) is at least partially formed by the two separate housing channels (86a, 86b).

2. Sensor head (8) according to Claim 1,
wherein the insulation layer (76) is formed by a radial (78) air gap (80) between the electronics housing (84) and the sensor head housing (14) of at least 1%, preferably 2%, of the maximum diameter (D) of the electronics housing (84).

3. Sensor head (8) according to Claim 1 or 2,
wherein the insulation layer (76) extends peripherally over at least 270°, preferably over more than 230°, around the electronics housing (84) in the tangential direction (82).

4. Sensor head (8) according to one of the preceding claims,
wherein the insulation layer (76) extends over at least half the axial length (L) of the electronics housing (84) in the axial direction (28).

5. Sensor head (8) according to one of the preceding claims,
wherein the gap (90) has a tangential opening angle (94) of at least 30°, preferably 60°.

6. Sensor head (8) according to one of the preceding claims,
wherein the at least two separate housing segment shells (86a, 86b) have an internally formed tangential groove (106a-112a, 106b-112b), which is in the form of an arc of a circle, and a circular-cylindrical outer face (92).

7. Sensor head (8) according to one of the preceding claims,
wherein the electronics unit (22) comprises a first printed circuit board (36), a second printed circuit board (38) and at least one third printed circuit board (40) in at least three parallel planes (50, 52, 54) - which are arranged axially one above the other -, a first flexible flat cable (64) electrically conductively connects the first printed circuit board (36) to the second printed circuit board (38), a second flexible flat cable (66) electrically conductively connects the second printed circuit board (40) to the third printed circuit board (42), and the two flexible flat cables (64, 66) are arranged in a meandering manner in the axial direction (28) so as to connect the printed circuit boards (36, 38, 40).

8. Sensor head (8) according to one of the preceding claims,
comprising a sensor optical system (32) having at least one optical element (16) and one sensor (31) which is arranged at an axial distance (A14) in relation to the optical element (16), wherein the axial distance (A14) is adjusted by an axial distance adjusting element (104) which is at least indirectly inserted between the optical element (16) and the sensor (31).

9. Sensor head (8) according to Claim 8,
wherein the optical element (16) is mounted in the sensor head housing (14) or in the electronics housing (84).

10. Sensor head (8) according to one of the preceding claims,
comprising an interface element (100), which is arranged at an axial distance (A3) in relation to an edge (102) of the electronics housing (84), for conducting electrical signals, wherein the axial distance (A3) is adjusted by an axial distance adjusting element (34) which is at least indirectly inserted between the interface element (100) and the electronics housing (84).

11. System (122) comprising a plurality of sensor heads (8a, 8b) according to one of Claims 8 to 10,
wherein the axial distance adjusting elements (34a, 34b) (104a, 104b) of the sensor heads (8a, 8b), which axial distance adjusting elements are respectively arranged at the same location, have an axial thickness difference (A8, A12) of at least 0.2 mm, preferably at least 0.7 mm.

## Revendications

1. Tête de capteur (8) pour un missile (2), avec un boîtier de tête de capteur (14), une unité électronique (22) et un boîtier électronique (84) autour de l'unité électronique (22),
a) le boîtier électronique (84) enveloppant au moins de façon prédominante l'unité électronique (22) et présentant un contour extérieur (92) essentiellement symétrique en rotation, et étant disposé, parallèlement à l'axe de rotation (24, 26), dans une cavité (20) symétrique en rotation formée par le boîtier de tête de capteur (14),
b) une couche d'isolation (76) thermique étant disposée entre le boîtier électronique (84) et le boîtier de tête de capteur (14),
c) le boîtier électronique (84) présentant une ouverture (88) courant sur au moins une fraction prédominante de la longueur axiale (L) du boîtier électronique (84), l'ouverture étant une lacune entre deux coques de boîtier (86a, 86b) séparées, et
d) le boîtier électronique (84) étant formé au moins partiellement par les deux coques de boîtier (86a, 86b) séparées.

2. Tête de capteur (8) selon la revendication 1,
la couche d'isolation (76) étant formée par un interstice d'air (80) radial (78) entre le boîtier électronique (84) et le boîtier de tête de capteur (14) égal à au moins 1 %, de préférence à 2 %, du diamètre (D) maximal du boîtier électronique (84).

3. Tête de capteur (8) selon la revendication 1 ou 2, la couche d'isolation (76) s'étendant dans la direction tangentielle (82) de façon périphérique sur au moins 270°, de préférence sur plus de 330°, autour du boîtier électronique (84).

4. Tête de capteur (8) selon l'une des revendications précédentes,
la couche d'isolation (76) s'étendant dans la direction axiale (28) sur au moins la moitié de la longueur axiale (L) du boîtier électronique (84).

5. Tête de capteur (8) selon l'une des revendications précédentes,
la lacune (90) présentant un angle d'ouverture (94) tangentiel d'au moins 30°, de préférence de 60°.

6. Tête de capteur (8) selon l'une des revendications précédentes,
les au moins deux coques de segment de boîtier (86a, 86b) séparées présentant une rainure tangentielle (106a-112a, 106b-112b) en forme d'arc de cercle constituée intérieurement, et une surface extérieure (92) en forme de cylindre circulaire.

7. Tête de capteur (8) selon l'une des revendications précédentes,
l'unité électronique (22) comprenant une première (36), une deuxième (38) et au moins une troisième platine (40) dans au moins trois plans (50, 52, 54) parallèles, avec une disposition axialement superposée, un premier câble plat (64) flexible raccordant de façon électriquement conductrice la première (36) à la deuxième platine (38), un deuxième câble plat (66) flexible raccordant de façon électriquement conductrice la deuxième (40) à la troisième platine (42), et les deux câbles plats (64, 66) flexibles étant disposés en raccordant de façon sinueuse les platines (36, 38, 40) dans la direction axiale (28).

8. Tête de capteur (8) selon l'une des revendications précédentes,
avec une optique de capteur (32) avec au moins un élément optique (16) et un capteur (31) disposé à une distance axiale (A14) de l'élément optique (16), la distance axiale (A14) étant ajustée par un élément d'ajustement de distance axiale (34) inséré entre l'élément optique (16) et le capteur (31).

9. Tête de capteur (8) selon la revendication 8,
l'élément optique (16) étant supporté dans le boîtier de tête de capteur (14) ou dans le boîtier électronique (84).

10. Tête de capteur (8) selon l'une des revendications précédentes,
avec un élément d'interface (100) disposé à une distance axiale (A3) d'une arête (102) du boîtier électronique (84) pour la conduite de signaux électriques, la distance axiale (A3) étant ajustée par un élément d'ajustement de distance axiale (104) inséré au moins indirectement entre l'élément d'interface (100) et le boîtier électronique (84).

11. Système (122) composé de plusieurs têtes de capteur (8a, 8b) selon l'une des revendications 8 à 10,
les éléments d'ajustement de distance axiale (34a, 34b) (104a, 104b), disposés respectivement au même endroit, des têtes de capteur (8a, 8b) présentant une différence d'épaisseur axiale (A8, A12) d'au moins 0,2 mm, de préférence d'au moins 0,7 mm.
